# FASCICULE DE BREVET EUROPEEN

(11) **EP 0 593 660 B1**
(45) Date de publication et mention de la délivrance du brevet: **25.09.1996**
(21) Numéro de dépôt: 92915830.1
(22) Date de dépôt: 08.07.1992
(51) Int. Cl.: H03B 9/10, H05B 6/66

(54) **DISPOSITIF DE DETECTION DU DYSFONCTIONNEMENT D'UNE CHARGE TELLE QU'UN MAGNETRON**
Einrichtung zum Detektieren der Dysfunktion eines Verbrauchers wie ein Magnetron
DEVICE FOR DETECTING THE ABNORMAL OPERATION OF A LOAD SUCH AS A MAGNETRON

(30) Priorité: 09.07.1991 FR 9108576
(43) Date de publication de la demande: 27.04.1994
(73) Titulaire: MOULINEX S.A., F-93170 Bagnolet (FR)
(72) Inventeur: DAUGE, Gilbert, F-77400 Lagny-sur-Marne (FR)
(74) Mandataire: May, Hans Ulrich, Dr.
(86) Numéro de dépôt international: FR9200655
(87) Numéro de publication internationale: WO9301654

(56) Documents cités:
- EP-A- 0 289 032
- US-A- 4 933 830

## Description

L'invention concerne la commande d'une charge unidirectionnelle en courant placée dans un circuit d'alimentation en tension continue ou redressée telle que par exemple, un magnétron et plus particulièrement un dispositif de détection du dysfonctionnement de ladite charge. De tel dispositif existe, voir par exemple le document EP-A 0 289 032.

Une charge unidirectionnelle en courant telle que, par exemple, un magnétron fonctionnant au démarrage avec une puissance de consigne élevée et branchée aux bornes de l'enroulement secondaire d'un transformateur haute tension d'une source d'alimentation subit parfois, lors de son fonctionnement, des fluctuations de tension dues aux variations de puissance et de température. Lesdites fluctuations provoquent des variations indésirables de la puissance de sortie qui entraînent, généralement, un échauffement du magnétron. Par conséquent, une répétition des fluctuations de tension entraînerait une détérioration dudit magnétron.

Le but de l'invention est de remédier à cet inconvénient en montant sur la source d'alimentation de la charge unidirectionnelle, un dispositif permettant de contrôler le fonctionnement de la charge unidirectionnelle pour éviter les renouvellements trop fréquents des fluctuations de tension.

Selon l'invention, le dispositif de détection du dysfonctionnement d'une charge unidirectionnelle comporte :
- un moyen de mesure de la valeur crête de tension aux bornes de l'enroulement secondaire du transformateur haute-tension ;
- un moyen de mémorisation de ladite valeur de tension mesurée à des instants successifs ;
- un moyen de comparaison entre deux valeurs successives de tensions délivrant, dans le cas d'un écart de valeur, un signal de dépassement et ;
- un moyen de détection du signal de dépassement pour calculer la fréquence d'apparition du dysfonctionnement de ladite charge.

Grâce au dispositif selon l'invention, les fluctuations de tension sont mesurées, mémorisées et analysées pour surveiller le fonctionnement de la charge unidirectionnelle telle qu'un magnétron. Ainsi, les échauffements réguliers de la charge unidirectionnelle sont limités, voire même supprimés, ce qui prolonge la durée de vie du magnétron et protège les composants électriques et électroniques contre les surtensions. En outre, on peut s'abstenir de mettre des sécurités coûteuses dans le circuit d'alimentation ce qui permet de réaliser une économie.

Les caractéristiques et avantages de l'invention apparaîtront dans la description qui va suivre à titre d'exemple non limitatif, en référence aux dessins annexés dans lesquels :

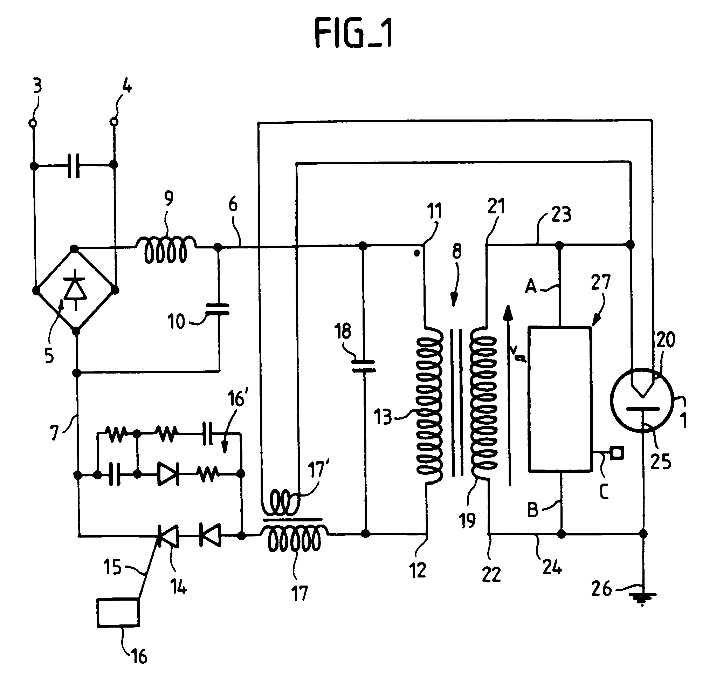

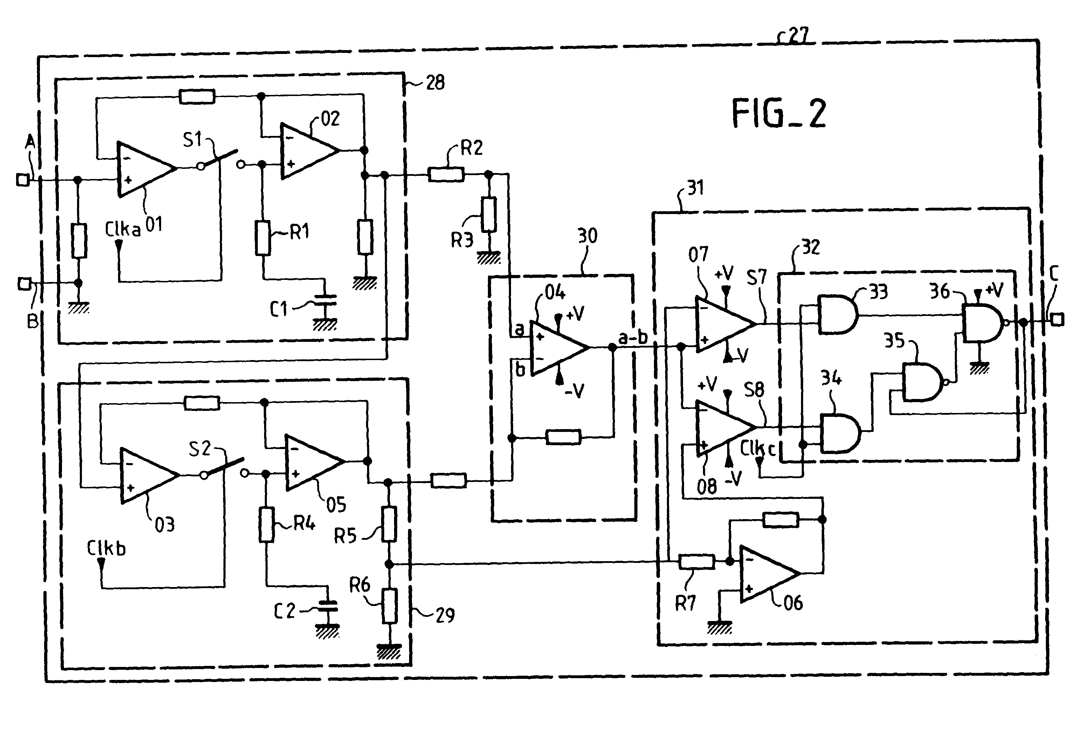

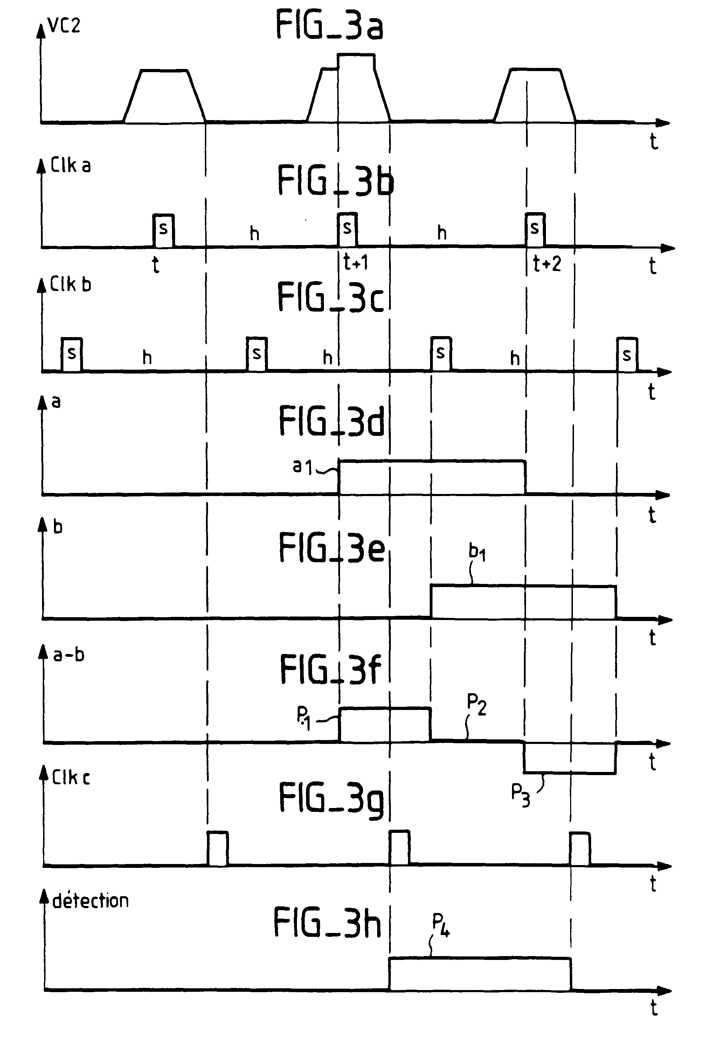

la figure 1 représente un exemple de montage d'un dispositif de détection du dysfonctionnement selon l'invention et positionné dans un circuit d'alimentation d'un magnétron ; la figure 2 représente un circuit d'un dispositif de détection du dysfonctionnement d'une charge unidirectionnelle, adaptée à être monté dans le circuit de la figure 1 ; la figure 3 représente des courbes de signaux de tension et d'horloge servant à expliquer le fonctionnement du dispositif selon l'invention.

Dans l'exemple de réalisation décrit sur la figure 1, le circuit est destiné plus particulièrement à l'alimentation d'un magnétron 1 d'un four à micro-ondes à partir d'un réseau alternatif de distribution arrivant aux bornes 3 et 4 du circuit. Ces bornes 3 et 4 sont reliées à un redresseur 5 qui est formé par un pont de diodes double alternance et dont la sortie est branchée à deux lignes 6 et 7 d'alimentation d'un transformateur haute tension 8. Le redresseur 5 comporte en sortie un filtre d'antiparasitage constitué par une bobine 9 et un condensateur 10. Les lignes 6 et 7 sont branchées respectivement aux extrémités 11 et 12 de l'enroulement primaire 13 du transformateur 8. La ligne 7 comporte également un élément de commutation 14 présentant une gâchette 15 reliée à un circuit de commande 16. Ledit élément de commutation 14 est constitué par un interrupteur unidirectionnel en courant. Le circuit comporte également un condensateur 18 branché en parallèle audit enroulement 13, ainsi qu'une self induction 17 montée en série avec l'ensemble ainsi constitué par le condensateur 18 et l'enroulement primaire 13. La self induction 17 est couplée à un enroulement secondaire 17' dont les extrémités sont reliées à l'élément chauffant 20 du magnétron 1.

L'enroulement secondaire 19 dudit transformateur 8 comporte respectivement deux bornes 21 et 22 branchées respectivement à deux lignes d'alimentation 23 et 24 reliées l'une 23 à la cathode 20 du magnétron 1 et l'autre 24, à l'anode 25 dudit magnétron qui est relié également à la masse 26.

Le dispositif de détection 27 du dysfonctionnement du magnétron est branché, par exemple, en parallèle aux bornes de l'enroulement secondaire 19 sur les lignes d'alimentation 23 et 24 par des lignes d'alimentation A et B. Ce dispositif de détection 27 comporte une ligne de sortie C émettant un signal de détection qui sera traité par un étage de correction d'erreurs (non représenté) commandant des moyens de régulation de l'alimentation du magnétron.
Selon la figure 2, le dispositif de détection 27 du dysfonctionnement du magnétron comporte un moyen de mesure 28 de la valeur de tension aux bornes 21 et 22 de l'enroulement secondaire du transformateur haute tension 8 à un instant déterminé, la valeur mesurée étant la valeur crête de la tension, un moyen de mémorisation 29 de ladite valeur crête de la tension aux différents instants successifs, un moyen de comparaison 30 entre deux valeurs successives délivrant, dans le cas d'un écart de valeur, un signal de dépassement, et un moyen de détection 31 de l'apparition du dysfonctionnement de ladite charge analysant ledit signal de dépassement.
La ligne d'alimentation A est connectée à l'entrée non inverseuse d'un amplicateur opérationnel O1 contenu dans un premier circuit intégré LF 398 de chez THOMSON. La sortie de cet amplificateur opérationnel est connectée à l'entrée d'un dispositif de commutation S₁ contenu également dans ledit premier circuit intégré. Le dispositif de commutation S₁ est commandé par une horloge clk a déclenchant l'activation de la mesure de tension crête V_{C2} à un instant déterminé sur un niveau montant de la tension générée par un oscillateur de tension. La sortie de ce dispositif de commutation S₁ est reliée, d'une part, à l'entrée non inverseuse d'un amplificateur opérationnel O2 faisant partie intégrante du circuit intégré LF 398, et, d'autre part, à un condensateur C₁ monté en série avec une résistance R₁ et permettant de se charger à la valeur V_{C2} lorsque le dispositif de commutation S₁ est fermé et de se décharger de ladite valeur lorsque le dispositif de commutation S₁ est ouvert. La sortie de l'amplificateur opérationnel O2 est reliée, d'une part, à l'entrée non inverseuse d'un amplificateur opérationnel O3 d'un deuxième circuit intégré LF 398 et, d'autre part, à un diviseur de tension R₂, R₃ dont le point de jonction est relié à l'entrée non inverseuse d'un amplificateur opérationnel O4 d'un circuit intégré LM 101 de chez SIEMENS.

La sortie de cet amplificateur opérationnel O3 est reliée à l'entrée d'un dispositif de commutation S₂ contenu dans le deuxième circuit intégré. Le dispositif de commutation S₂ est commandé par une horloge clk b fonctionnant de la même manière que l'horloge clk a mais déclenché à des intervalles de temps différents. La sortie du dispositif de commutation S₂ est reliée, d'une part, à l'entrée non inverseuse d'un amplificateur opérationnel O5 du deuxième circuit intégré LF 398 et, d'autre part, à un condensateur C₂ monté en série avec une résistance R₄ et permettant de mémoriser la valeur de la tension V_{C2} contenue dans le condensateur C₁ lorsque le dispositif de commutation S₂ est fermé, le dispositif de commutation S₁ étant ouvert. La sortie de l'amplificateur opérationnel O5 est connectée, d'une part, à l'entrée inverseuse de l'amplificateur opérationnel O4, et, d'autre part, à une extrémité d' un diviseur de tension R₅, R₆ déterminant une valeur seuil de la tension de fonctionnement du magnétron, l'autre extrémité dudit diviseur de tension R₅, R₆ étant reliée à la borne négative de tension. Le point de jonction des résistances R₅ et R₆ est relié, d'une part, par l'intermédiaire d'une autre résistance R₇ à l'entrée inverseuse d'un amplificateur opérationnel O6 d'un comparateur à fenêtre TCA 965 de chez Siemens, et, d'autre part, à l'entrée inverseuse d'un amplificateur opérationnel O₇. L'amplificateur opérationnel O4 mesure la différence entre la valeur a de la tension crête V_{C2} mesurée à l'instant t et la valeur b de la tension crête précédente V_{C2} à l'instant t-1, le signal correspondant à cette différence a-b est envoyé sur l'entrée non inverseuse de l'amplificateur opérationnel O7 du comparateur à fenêtre ainsi que sur l'entrée inverseuse d'un amplificateur opérationnel O8 du même comparateur à fenêtre. Les sorties S7 et S8 de ces amplificateurs opérationnels O7 et O8 sont connectées respectivement à un dispositif de portes logiques 32 comprenant au moins deux portes ET 33 et 34 dont l'une des entrées est connectée à une horloge clk c fonctionnant de la même manière que l'horloge clk a mais de façon décalée après chaque pulse de tension V_{C2} ainsi que des portes ET inverseuses 35 et 36. Le signal de sortie C du dispositif de portes logiques 32 permet, par attaque d'un moyen de comptage (non représenté), de définir avec exactitude la fréquence de répétition du dysfonctionnement. La sortie du moyen de comptage determinant la fréquence de répétition du dysfonctionnement est envoyé sur un des entrées d'un moyen de comparaison (non représenté), l'autre entrée étant relié à un composant (non représenté) delivrant une valeur de fréquence seuil. Suivant l'écart entre la valeur de fréquence de répétition du dysfonctionnement et la valeur de fréquence seuil, un signal de sortie du moyen de comparaison agit sur l'alimentation du magnétron soit par sa mise hors service soit par la variation de puissance de consigne P₀ de l'alimentation du four au démarrage, la mise hors service de l'alimentation et la variation de puissance de consigne P₀ étant commandés par un étage de correction d'erreurs.

La figure 3 a représente la tension crête qui apparaît aux bornes de l'enroulement secondaire et qui est mesurée pour détecter le dysfonctionnement du magnétron.

La figure 3 b représente le cycle de l'horloge clk a déclenchant l'activation du dispositif de commutation du moyen de mesure de la valeur crête de V_{C2}.

La figure 3 c représente le cycle de l'horloge clk b déclenchant l'activation du dispositif de commutation du moyen de mémorisation de la valeur crête de V_{C2} mesurée par le moyen de mesure.

La figure 3 d représente la tension mesurée a appliquée à l'entrée non inverseuse de l'amplificateur opérationnel O4.

La figure 3 e représente la tension mémorisée b appliquée à l'entrée inverseuse de l'amplification opérationnel O4.

La figure 3 f représente la différence de tension (a-b) entre la valeur crête de la tension V_{C2} mesurée à l'instant t et celle mesurée à l'instant t-1.

La figure 3 g représente le cycle de l'horloge clk c déclenchant l'activation du dispositif de portes logiques ET afin d'obtenir un signal pour le moyen de comptage permettant de définir la fréquence de répétition du dysfonctionnement du magnétron.

La figure 3 h représente un signal d'une détection du dysfonctionnement du magnétron.

Selon la figure 3 a, des valeurs crêtes V_{C2} de tensions successives sont détectées aux bornes de l'enroulement secondaire du transformateur. Chaque valeur de tension V_{C2} est mesurée par le moyen de mesure 28 lors de la fermeture du dispositif de commutation S₁ activé par l'horloge clk a comme représenté sur la figure 3 b. Ladite mesure de la tension V_{C2} est mémorisée par le moyen de mémorisation 29 lors de l'ouverture du dispositif de commutation S₁ du moyen de mesure 28, et la fermeture du dispositif de commutation S2 du moyen de mémorisation 29 (activation clk b). Les horloges clk a et clk b ont la même période mais sont déphasées, le déphasage de l'horloge clk a par rapport à l'horloge clk b correspondant à une demi-période.

Lors de la première mesure de tension V_{C2} à l'instant t, la valeur de tension étant sensiblement égale à une tension normale V_{C2} de fonctionnement du magnétron, aucun signal n'apparaît aux entrées a et b (figure 3 d et figure 3 e) de l'amplificateur opérationnel O4. Lors de la deuxième mesure de tension V_{C2} à l'instant t + 1, la valeur crête de tension V_{C2} étant supérieure à la tension normale V_{C2} de fonctionnement du magnétron, un signal a 1, (figure 3 d) apparaît à l'entrée non inverseuse de l'amplificateur opérationnel O4. L'horloge Clk b étant déclenchée avec un déphasage d'une demie-période, le signal b₁ (figure 3 e) apparaît à l'entrée inverseuse de l'ampli opérationnel. Ce dernier mesurant la différence de tension fait apparaître à sa sortie un signal (a-b) avec une impulsion positive P₁, pendant une demi-période comprise entre l'activation de l'horloge clk b et l'activation de l'horloge clk a, une impulsion nulle P₂ pendant une demi-période comprise entre l'activation de l'horloge clk b et une nouvelle activation de l'horloge clk a et une impulsion négative P₃ pendant une demi-période comprise entre l'activation de l'horloge clk a et l'activation de l'horloge clk b. L'impulsion positive P₁ correspond à la variation de la valeur crête de tension V_{C2} entre une valeur crête de tension normale à l'instant t, par exemple, V_{C2} à peu près égale à 4000 V et une valeur crête de tension anormale V_{C2} à l'instant t + 1 à peu près égale à 4800 V. L'impulsion négative P₃ correspond à la variation de la valeur crête de tension V_{C2} entre la valeur crête de tension anormale V_{C2} à l'instant t + 1 et la valeur crête de tension normale V_{C2} à l'instant t + 2.
Les impulsions de l'horloge clk c, (figure 3 g) sont déphasées par rapport aux impulsions des horloges clk a et clk b. Les impulsions de cette horloge clk c sont déclenchées à la fin de chaque signal V_{C2} apparu aux bornes de l'enroulement secondaire et représentée sur la figure 3 a pour analyser le signal a-b (figure 3 f). Sur la sortie C du dispositif de portes logiques 32 (figure 3 h) représentant le signal de détection du dysfonctionnement de la charge, en l'occurrence le magnétron, on obtient une impulsion positive P₄ dès que sur la sortie de l'amplificateur O4, est détectée une impulsion positive P₁ de variation de tension V_{C2}.

De part la période de cette impulsion, on détermine la fréquence d'apparition du dysfonctionnement de la charge. En effet, dans notre cas particulier, l'impulsion P₄ a une durée d'apparition équivalente à la période de l'horloge clk c*,* la rupture de cette impulsion P₄ s'effectuant pendant l'apparition sur la sortie de l'amplificateur O4 de l'impulsion négative P₃ signalant une variation importante de la valeur crête de tension V_{C2}. Le dysfonctionnement de la charge étant ainsi détecté, un comptage de ladite fréquence d'apparition permet d'agir sur l'étage de correction d'erreurs empêchant toute détérioration de la charge telle le magnétron, soit par coupure de l'alimentation soit par régulation de la puissance de consigne de démarrage P₀ de ladite charge.

## Revendications

1. Dispositif de détection du dysfonctionnement d'une charge unidirectionnelle en courant qui fonctionne au démarrage avec une puissance de consigne élevée Po, et qui est branchée aux bornes (21,22) de l'enroulement secondaire (19) d'un transformateur haute-tension (8), faisant partie d'un circuit d'alimentation électrique de ladite charge
**caractérisé en ce qu**'il comporte, un moyen de mesure (28) de la valeur de tension crête prélevée dans ledit circuit d'alimentation, un moyen de mémorisation (29) de ladite valeur de tension mesurée à des instants successifs, un moyen de comparaison (30) entre deux valeurs successives de tensions délivrant, dans le cas d'un écart de valeur, un signal de dépassement (a-b), et un moyen de détection (31) du signal de dépassement adapté à émettre un signal d'un dysfonctionnement vers un moyen de comptage pour déterminer la fréquence dudit dysfonctionnement .

2. Dispositif de détection selon la revendication 1,
**caractérisé en ce que**, la charge unidirectionnelle en courant est un magnétron (1) .

3. Dispositif de détection selon la revendication 1 ou 2,
**caractérisé en ce que**, le moyen de mesure (28) est branché aux bornes de l'enroulement secondaire du transformateur haute-tension (8).

4. Dispositif de détection selon la revendication 3,
**caractérisé en ce que**, le moyen de mesure (28) de la valeur crête de tension aux bornes de l'enroulement secondaire du transformateur haute-tension comporte un amplificateur opérationnel 0₁ dont l'entrée non inverseuse est reliée aux bornes de l'enroulement secondaire du transformateur (8), un dispositif de commutation S₁ déclenché par une horloge Clk a et connecté à la sortie de l'amplificateur opérationnel O₁, un condensateur C₁ branché entre la sortie du dispositif de commutation S₁ et la masse, et un amplificateur opérationnel O₂ dont l'entrée non inverseuse est connectée à la sortie du dispositif de commutation S₁.

5. Dispositif de détection selon l'une quelconque des revendications précédentes,
**caractérisé en ce que**, le moyen de mémorisation (29) de la valeur crête de tension comporte un amplificateur opérationnel (O₄) dont l'entrée non inverseuse est reliée à la sortie de l'amplificateur opérationnel O₂, un dispositif de commutation S₂ activé par une horloge Clk b et branché à la sortie de l'amplificateur opérationnel O₃, un condensateur C₂ monté en série avec une résistance R₄ entre la masse et la sortie du dispositif de commutation S₂, ainsi qu'un amplificateur opérationnel O₅ dont l'entrée non inverseuse est connectée à la sortie du dispositif de commutation S₂ et à la résistance R₄.

6. Dispositif de détection selon la revendication 5,
**caractérisé en ce que**, le moyen de comparaison (30) comprend un amplificateur opérationnel O₆ dont l'entrée inverseuse est connectée à la sortie de l'amplificateur opérationnel O₅ et l'entrée non inverseuse est connectée à un point de jonction d'un diviseur de tension (R₂,R₃) relié à la sortie de l'amplificateur opérationnel O₂.

7. Dispositif de détection selon la revendication 6,
**caractérisé en ce que** le moyen de détection (31) comprend deux amplificateurs opérationnels O₇ et O₈ dont deux entrées de polarité inverse sont reliées en commun au signal de sortie (a-b) de l'amplificateur opérationnel O₄, et dont les deux autres entrées sont connectées respectivement d'une part, à un diviseur de tension (R₅, 5₆) déterminant une valeur seuil de tension de fonctionnement du magnétron, et, d'autre part, à la sortie d'un amplificateur opérationnel O₆ dont l'entrée inverseuse est reliée audit diviseur de tension (R₅, R₆), ainsi qu'un dispositif de portes logiques ET (32) commandées par une horloge Clk c et permettant de détecter le dysfonctionnement.

8. Dipositif de détection selon la revendication selon la revendication 1,
**caractérisé en ce que** ledit dispositif est connecté aux bornes d'un enroulement secondaire complémentaire du transformateur haute-tension (8).

## Patentansprüche

1. Abtastvorrichtung zum Ermitteln einer Funktionsstörung bei einer unidirektionellen Stromlast, die beim Anlaufen mit einer erhöhten Stelleistung Po arbeitet und die an den Anschlüssen (21, 22) der Sekundärwicklung (19) eines Hochspannungstransformators (8) angeschlossen ist, der einen Teil eines elektrischen Versorgungskreises für die besagte Last bildet,
**dadurch gekennzeichnet,** daß sie die folgenden Merkmale aufweist:
ein Meßmittel (28) zur Messung des in besagtem Versorgungskreis abgenommenen Spitzenspannungswertes,
ein Speichermittel (29) zur Speicherung des besagten, zu aufeinanderfolgenden Zeitpunkten gemessenen Spannungswertes,
ein Vergleichsmittel (30) zum Vergleichen zweier aufeinanderfolgener Spannungswerte, das im Fall eines Unterschieds der Werte ein Überschreitungssignal (a-b) liefert, und
ein Abtastmittel (31) zum Ermitteln des Überschreitungssignals, das dafür angepasst ist, ein Funktionsstörungssignal auszusenden, und zwar zu einem Zählmittel zum Bestimmen der Frequenz der besagten Funktionsstörung.

2. Abtastvorrichtung gemäß Anspruch 1, **dadurch gekennzeichnet, daß** die unidirektionelle Stromlast ein Magnetron (1) ist.

3. Abtastvorrichtung gemäß Anspruch 1 oder 2, **dadurch gekennzeichnet, daß** das Meßmittel (28) an den Anschlüssen der Sekundärwicklung des Hochspannungstransformators (8) angeschlossen ist.

4. Abtastvorrichtung gemäß Anspruch 3, **dadurch gekennzeichnet, daß** das Meßmittel (28) zur Messung des Spitzenspannungswertes an den Anschlüssen der Sekundärwicklung des Hochspannungstransformators die folgenden Merkmale aufweist:
einen Operationsverstärker O₁, dessen nicht-invertierender Eingang mit den Anschlüssen der Sekundärwicklung des Transformators (8) verbunden ist,
eine Schaltvorrichtung S₁, die durch einen Zeitgeber Clk a ausgelöst wird und die am Ausgang des Operationsverstärkers O₁ angeschlossen ist,
einen Kondensator C₁, der zwischen den Ausgang der Schaltvorrichtung S₁ und der Masse geschaltet ist, und
einen Operationsverstärker O₂, dessen nicht-invertierender Eingang mit dem Ausgang der Schaltvorrichtung S₁ verbunden ist.

5. Abtastvorrichtung gemäß einem der vorhergehenden Ansprüche, **dadurch gekennzeichnet,** daß das Speichermittel (29) zur Speicherung des Spitzenspannungswertes die folgenden Merkmale aufweist:
einen Operationsverstärker (O₄), dessen nicht-invertierender Eingang mit dem Ausgang des Operationsverstärkers O₂ verbunden ist,
eine Schaltvorrichtung S₂, die durch einen Zeitgeber Clk b aktiviert wird und die mit dem Ausgang des Operationsverstärkers O₃ verbunden ist,
einen Kondensator C₂, der in Reihe mit einem Widerstand R4 zwischen der Masse und dem Ausgang der Schaltvorrichtung S₂ geschaltet ist, und
einen Operationsverstärker O₅, dessen nicht-invertierender Eingang mit dem Ausgang der Schaltvorrichtung S₂ und mit dem Widerstand R₄ verbunden ist.

6. Abtastvorrichtung gemäß Anspruch 5, **dadurch gekennzeichnet, daß** das Vergleichsmittel (30) einen Operationsverstärker O₆ aufweist, dessen invertierender Eingang mit dem Ausgang des Operationsverstärkers O₅ verbunden ist und dessen nicht-invertierender Eingang bei einem Verbindungspunkt eines Spannungsteilers (R₂, R₃) angeschlossen ist, der mit dem Ausgang des Operationsverstärker O₂ verbunden ist.

7. Abtastvorrichtung gemäß Anspruch 6, **dadurch gekennzeichnet, daß** das Abstastmittel (31) die folgenden Merkmale aufweist:
zwei Operationsverstärker O₇ und O₈, deren beide Eingänge mit inverser Polarität gemeinsam mit dem Ausgangssignal (a-b) des Operationsverstärkers O₄ verbunden sind und deren andere beiden Eingänge jeweils zum einen mit einem Spannungsteiler (R₅, R₆), der einen Spannungsschwellenwert der Funktion des Magnetrons festlegt, und zum anderen mit dem Ausgang eines Operationsverstärkers O₆ verbunden sind, wobei der invertierende Eingang des Operationsverstärkers O₆ mit besagtem Spannungsteiler (R₅, R₆) verbunden ist, und
eine logische UND-Gatter aufweisende Logikvorrichtung (32), die durch einen Zeitgeber Clk c gesteuert wird und die es gestattet, die Funktionsstörung zu ermitteln.

8. Abtastvorrichtung gemäß Anspruch 1, **dadurch gekennzeichnet, daß** besagte Vorrichtung bzw. Abtastvorrichtung mit den Anschlüssen einer komplementären Sekundärspule des Hochspannungstransformators (8) verbunden ist.

## Claims

1. Device for detecting malfunctioning of a unidirectional current load which functions at start-up with a high set power Po, and which is connected to the terminals (21, 22) of the secondary winding (19) of a high-voltage transformer (8), forming part of an electrical power supply circuit for the said load, characterised in that it includes a means (28) of measuring the peak voltage value taken from the said power supply circuit, a means (29) of storing the said voltage value measured at successive instants, a means (30) of comparing two successive voltage values delivering, in the event of a difference in value, an exceed signal (a-b), and a means (31) of detecting the exceed signal adapted to send a malfunction signal to a counting means in order to determine the frequency of the said malfunctioning.

2. Detection device according to Claim 1, characterised in that the unidirectional current load is a magnetron (1).

3. Detection device according to Claim 1 or 2, characterised in that the measuring means (28) is connected to the terminals of the secondary winding of the high-voltage transformer (8).

4. Detection device according to Claim 3, characterised in that the means (28) of measuring the peak voltage value at the terminals of the secondary winding of the high-voltage transformer includes an operational amplifier O₁ whose non-inverting input is connected to the terminals of the secondary winding of the transformer (8), a switching device S₁ triggered by a clock clk a and connected to the output of the operational amplifier O₁, a capacitor C₁ connected between the output of the switching device S₁ and earth, and an operational amplifier O₂ whose non-inverting input is connected to the output of the switching device S₁.

5. Detection device according to any one of the preceding claims, characterised in that the means (29) of storing the peak voltage value includes an operational amplifier (O₄) whose non-inverting input is connected to the output of the operational amplifier O₂, a switching device S₂ activated by a clock clk b and connected to the output of the operational amplifier O₃, a capacitor C₂ mounted in series with a resistor R₄ between earth and the output of the switching device S₂, and an operational amplifier O₅ whose non-inverting input is connected to the output of the switching device S₂ and to the resistor R₄.

6. Detection device according to Claim 5, characterised in that the comparison means (30) comprises an operational amplifier O₆ whose inverting input is connected to the output of the operational amplifier O₅ and whose non-inverting input is connected to a connection point of a voltage divider (R₂, R₃) connected to the output of the operational amplifier O₂.

7. Detection device according to Claim 6, characterised in that the detection means (31) comprises two operational amplifiers O₇ and O₈ whose two inputs of reverse polarity are connected in common to the output signal (a-b) of the operational amplifier O₄, and whose other two inputs are connected respectively on the one hand to a voltage divider (R₅, R₆) determining a threshold value of the operating voltage of the magnetron and on the other hand to the output of an operational amplifier O₆ whose inverting input is connected to the said voltage divider (R₅, R₆), and a logical AND gate device (32) controlled by a clock clk c and enabling malfunctioning to be detected.

8. Detection device according to Claim according to Claim 1, characterised in that the said device is connected to the terminals of a complementary secondary winding of the high-voltage transformer (8).
